# EUROPEAN PATENT SPECIFICATION

(11) **EP 0 363 116 B1**
(45) Date of publication and mention of the grant of the patent: **04.08.1993**
(21) Application number: 89310035.4
(22) Date of filing: 02.10.1989
(51) Int. Cl.: G01B 7/08

(54) **Glass container wall thickness inspection apparatus**
Apparat zum Prüfen der Wanddicke von Glasbehältern
Appareil d'inspection de l'épaisseur des parois de récipient en verre

(30) Priority: 05.10.1988 US 253827
(43) Date of publication of application: 11.04.1990
(73) Proprietor: Emhart Glass Machinery Investments Inc., Wilmington, Delaware 19801 (US)
(72) Inventor: Scott, Paul F., Hartford Connecticut 06106 (US)
(74) Representative: Wetters, Basil David Peter

(56) References cited:
- EP-A- 0 300 616
- FR-A- 2 435 696
- US-A- 2 285 152
- US-A- 4 228 393

## Description

A bottle or container is formed from a gob of molten glass in an individual section glass container forming machine by first pressing or blowing the gob into a parison and then blowing the parison into the container. When glass is uniformly distributed in this process, wall thickness will be uniform, but when glass distribution is not uniform, thin spots can occur which may result in bottle failure during filling or handling.

The high dielectric constant of glass makes it possible to measure the electrical capacitance of the wall of a glass container located against two elongated electrodes of a sensor which contact the bottle as it is rolled along the sensor. This capacitance increases monotonically as the thickness of the glass container increases and can be measured using an electronic circuit to convert the capacitance to a voltage. A voltage representative of the thickness of the wall can be continuously generated as the bottle rolls along the sensor, and if the voltage decreases below a selected value (the value which represents the minimal wall thickness), the bottle being tested can be rejected.

European Patent Application 300,616, applied for before the priority date of the present application but not published until after that priority date, discloses a glass container inspection apparatus for measuring the thickness of the wall of a bottle by use of an elongated electrode which is resiliently pressed against the bottle while the bottle is rolled along the electrode. Such an inspection machine is capable of operation at a higher seed with more accuracy than one in which the bottle is rotated in place, particularly because of problems caused by slight variations in the shape of the bottle.

Most glass container inspection apparatuses presently available suffer from accuracy problems due to measuring the small changes in capacitance caused by changes in wall thickness (typically on the order of 10⁻³ Picofarad change in measured capacitance per 2.54 x 10⁻⁵ m change in wall thickness) and the non-linear change in capacitance as a function of thickness over the range provided by glass containers.

US A-2285152 discloses an apparatus for measuring the wall thickness of a glass container comprising a capacitance sensor, in the form of two electrodes, and container presenting means for presenting a container to engage the sensor. The apparatus comprises an oscillator assembly comprising an oscillator which provides an oscillating current to the sensor and an amplifier arrangement which provides an output signal representative of the capacitance sensed by the sensors.

Interpretation of the output signal requires calibrationof the apparatus against known samples: this is not in general satisfactory, particularly towards the extremes of the thicknesses being increased It is an object of the present invention to provide an apparatus for inspecting the wall thickness of a glass container in which a voltage representing the sensed capacitance of a portion of the wall of the container is converted into a voltage accurately representing the thickness of the portion of the wall of the container.

The present invention provides apparatus for measuring the wall thickness of a glass container comprising
a capacitance sensor
container presenting means for presenting a container to engage the sensor
an oscillator assembly which provides an oscillating current to the sensor and an output signal representative of the capacitance sensed by the sensor
characterized in that
the apparatus also comprises computer means which is responsive to the output signal and converts the output signal empirically to data representing the wall thickness according to the formula 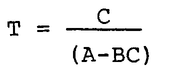
where T is the wall thickness
C is the sensed capacitance
A is an empirically determined coefficient appropriate to the linear relationship between capacitance and thickness when the thickness is small
B is an empirically determined coefficient appropriate to the non-linear relationship between capacitance and thickness when the thickness is large.

There now follows a description, to be read with reference to the accompanying drawings, of a preferred embodiment of a glass container inspection apparatus chosen to illustrate the invention by way of example.

In the accompanying drawings:
Figure 1 shows, diagrammatically, an inspection station of a glass container inspection apparatus;
Figure 2 is a logic diagram illustrating the operation of a controller of the apparatus to determine whether or not a container should be rejected;
Figure 3 shows, diagrammatically, mechanism for moving containers through the inspection station;
Figure 4 is a logic diagram illustrating steps to eliminate the effect of a side seam on inspection;
Figure 5 shows a container with a side seam and diagrammatically the effect of the logic illustrated in Figure 4;
Figure 6 is a schematic diagram illustrating the electronic circuit of the inspection apparatus.

The illustrative glass container inspection apparatus is for measuring the thickness of a wall of a container, for example a round glass bottle, by use of capacitance sensing means which produces a signal representative of the thickness of the wall of a bottle presented to it.

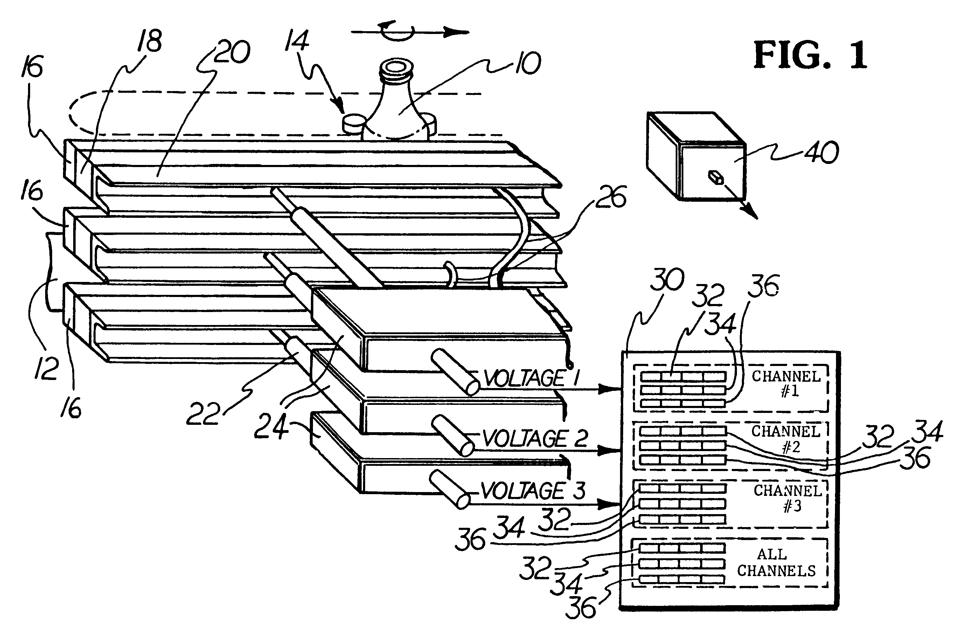

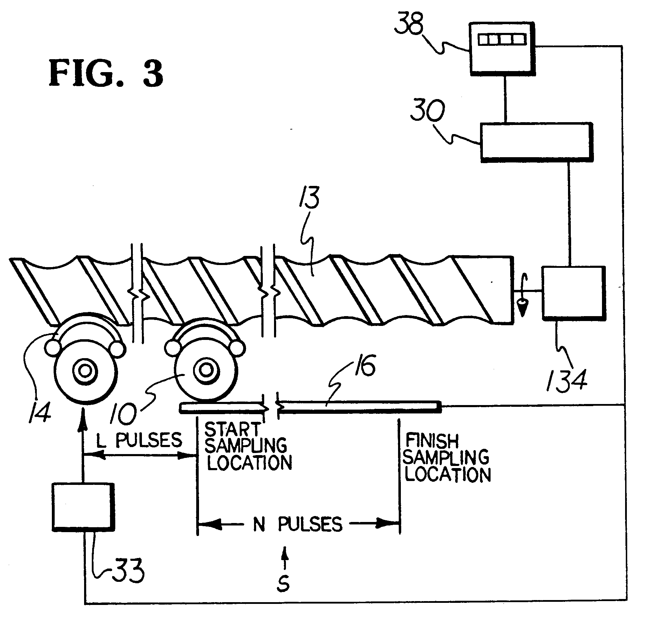

The illustrative apparatus comprises means for presenting a glass bottle to the sensing means so that its wall thickness may be sensed comprising bottle carriers 14 (Figures 1 and 3) which engage round glass bottles 10 supported on a plate 12. The carriers 14 are engaged by an elongated cam 13 which is rotated at a constant speed to carry the bottles in turn through an inspection station S. As each carrier 14 carries a bottle 10 through the inspection station S it rolls the bottle along a number (three as illustrated in Figure 1 for purposes of clarity, but four are normally used) of parallel horizontally extending, vertically spaced, elongated capacitance sensors 16 in the form of strips which are secured to resilient foam strips 18 mounted on suitable brackets 20. The brackets are connected by posts 22 to corresponding head oscillator assembly housings containing oscillator assemblies 24. Each oscillator assembly 24 receives a capacitance signal from its associated capacitance sensor 16 via a calibrated cable 26 and generates a continuous voltage signal which is supplied to a computer 30.

When the cam 13 carries a carrier 14 towards the inspection station S a start position of the carrier 14 is sensed by a suitable sensor 33. The rotational position of the cam 13 is monitored by an encoder 134 the encoder reading when the carrier 14 is at the start position is defined as the start pulse by the computer 30. As the cam continues to advance the carrier 14, a captured bottle 10 will be translated towards the right until the bottle engages the capacitance sensor 16 and reaches the beginning of the inspection station, as defined by a selected encoder pulse count (L). The sampling will then begin with a data sample being evaluated by the computer 30 at each subsequent count until the count reaches a selected number (N) which assures that the entire periphery of the bottle has been sampled (the Finish Sampling Location). For smaller bottles, a portion of this peripheral ring may be analysed twice. The operator inputs the diameter of the bottle via a hand held terminal or the like 38, and the computer sets the correct number (N) of pulses for the bottle.

The computer 30 of the illustrative apparatus comprises an array of settable thumb wheel switches 32, 34, 36 associated with each capacitance sensor, the switches 32 being adapted for setting a minimum wall thickness, the switches 34 a maximum wall thickness and the switches 36 a minimum/maximum wall thickness ratio.

Glass thickness measurements are made using each sensor 16 and cable 26 which have a capacitance about 50 pf without glass being sensed. The sensitivity of the sensor 16 to glass is about 0.002 pf of capacitance for each 2.54 x 10⁻⁵ m of glass and decreases as glass thickness increases.

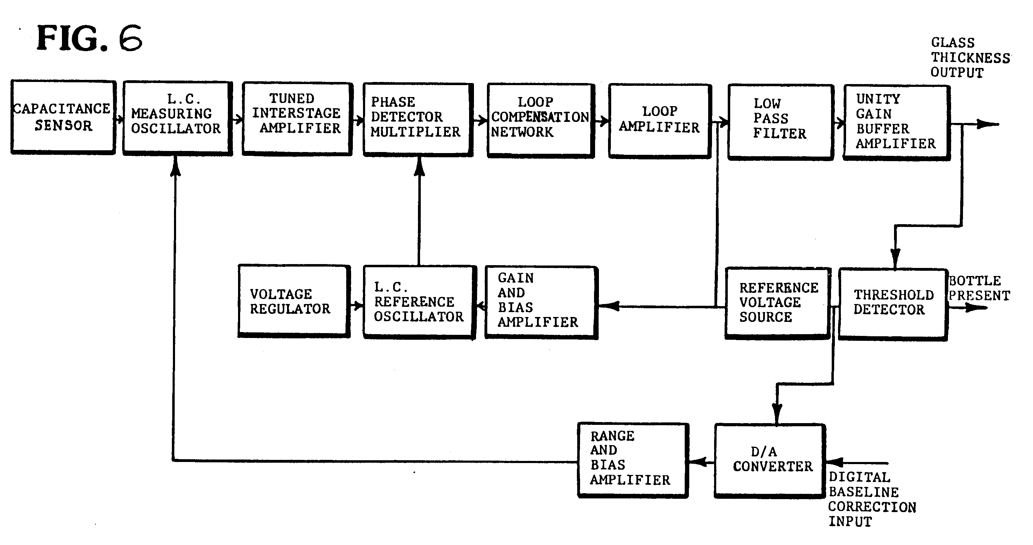

Each oscillator assembly 24 comprises [see Figure 6] a capacitance tuned Measuring Oscillator (a transformer coupled LC oscillator) formed by placing the sensor 16 in parallel with a ferrite pot core inductor which has an extra winding for feed-back. This measuring oscillator is tuned by the capacitance of the sensor and accordingly converts small changes in capacitance (a change in bottle thickness) to small changes in frequency. This output frequency is passed to a Tuned Interstage Amplifier which rejects signals that are outside the frequency range of interest. A capacitance tuned Reference Oscillator which is identical to the Measuring Oscillator is formed using an identical inductor and a stable capacitor that equals the no glass capacitance of the sensor and cable assembly.

To each oscillator is added some additional capacitance in the form of a varactor (a capacitor in series with a reversed biased tuning diode). The network values are chosen so that the diode can be biased by means of a biasing resistor over a range of voltages (from -3 to -10 volts). The value of the capacitance change due to the network and varactor is chosen to be approximately equal to the change in capacitance for the largest glass thickness expected.

Preferably the varactor bias of the Measuring Oscillator is set as a starting point approximately to the mid-point of its range and the bias of the varactor in the Reference Oscillator is set to its minimum point (-10 volts in the above example).

As will now be described, the computer 30 is arranged to be responsive to reject bottles if the signals produced by the sensors 16 indicate that the thickness of the wall of the container is, at any sensed point, greater than a selected maximum value or less than a selected minimum value or if the ratio of the signals representing the minimum sensed wall thickness to the maximum wall thickness is lower than a selected value.

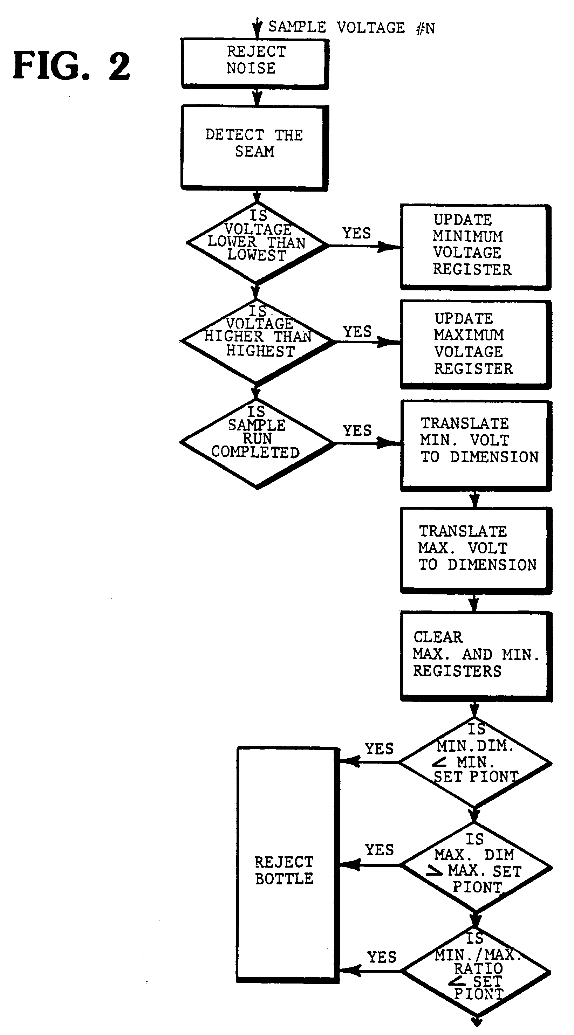

As can be seen from the logic diagram illustrated in Figure 2, in the computer 30 the voltage signal generated by each oscillator assembly is processed to Reject Noise (by averaging, for example). A Detect The Seam circuit determines that data in the vicinity of a seam is being generated and ignores this data which would produce a false thin spot reading, as will be described in more detail later. Two to three hundred readings or data samples are taken around the bottle at each sensor and then evaluated to identify the lowest and highest voltage around the bottle. These voltages are stored in suitable registers which are updated whenever a lower or higher voltage is sensed until readings have been taken completely around the bottle. A highest voltage and lowest voltage register can be provided for each sensor (channel) and a highest and lowest register can be provided for the data of all the sensors (channels). At this time, the voltage which represents the thinnest spot around the tested periphery (either for one or for all channels) and the voltage which represents the thickest spot around the tested periphery (either for one or for all channels) are converted via suitable A/D converters to dimensions (millimeter for example) and the registers are cleared for the next bottle. If the minimum dimension is less than the minimum set point, or if the maximum dimension is higher than the maximum set point or if the minimum to maximum ratio for these two dimensions is less than the minimum to maximum set point, the bottle will be rejected by a suitable reject mechanism 40, diagrammatically indicated in Figure 1.

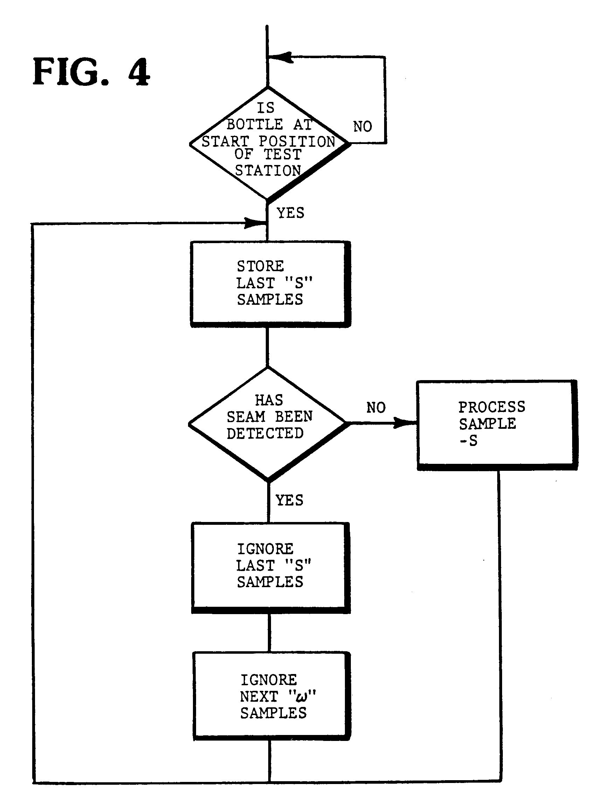

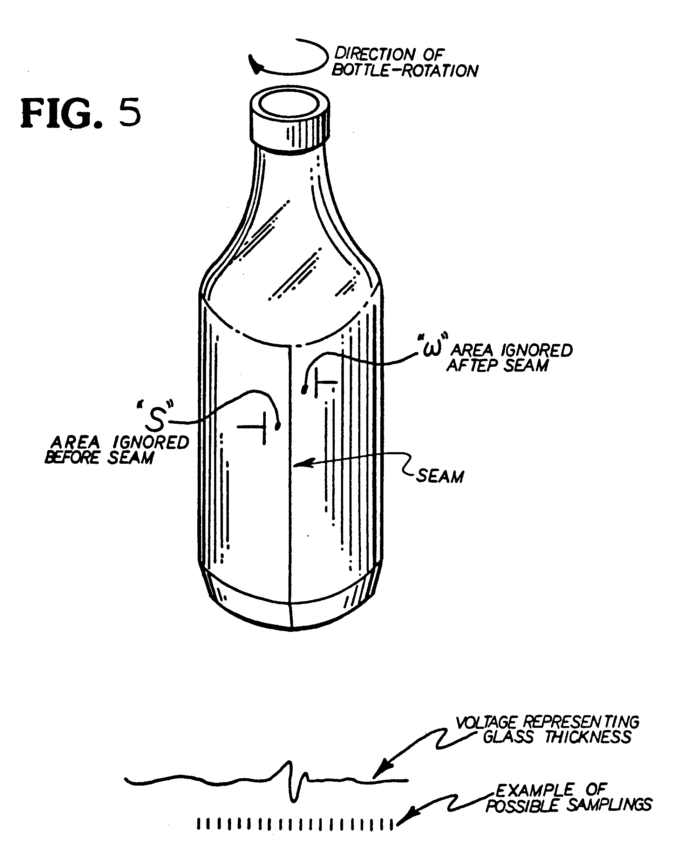

As can be seen from Figures 4 and 5, the last "S" (four, for example) data samples are stored in a Store Case "S" Sample and each time a new data sample is placed in storage, the oldest data sample will accordingly be evaluated at each pulse until the bottle wall seam has been detected by the computer 30 in a conventional manner; i.e. the computer 30 determines the rate of change or differential of the voltage representing glass thickness and whenever this differential exceeds a selected threshold, a seam has been detected. Thus the computer 30 includes a seam detector means. At this time, all the sample data in the Store Case "S" samples will be ignored as will future data samples for a "W" pulse count. "S" and "W" are settable, via a conventional computer input such as a keyboard, to cover a selected window during which seam data would normally be evaluated. Following the counting of "W" pulses, the sample data will again be evaluated each pulse until the Finish Sampling Location is reached.

Returning now to a more complete description of the capacitative wall thickness sensing circuit of Figure 6. A Phase Locked Loop is formed to adjust the voltage to exactly match the capacitance of the sensor and glass to the reference capacitance (the varactor) of the Reference Oscillator by coupling the two oscillator outputs with a Phase Detector Multiplier. The detected phase is fed to a Loop Compensation Network (a band width shaping filter) and Amplifier. Due to the gain of the Amplifier, a small error in phase will result in a substantial output voltage. The Loop is closed through a Gain and Bias Amplifier which is set as follows: When the amplifier output is at the desired minimum (0 volts in the illustrated case), the varactor is set to minimum capacitance (-10 volts to the varactor). The gain is set so that the desired maximum out of the amplifier (5 volts) sets the varactor to the maximum capacitance (-3 volts to the varactor).

The Phase Locked Loop is closed to force the Measuring Oscillator and the Reference Oscillator to operate at exactly the same frequencies. When no glass is sensed by the sensor, the frequencies are equal when the Reference Oscillator varactor is at minimum, so that the output of the Loop Amplifier is zero. As glass is sensed by the sensor, the output of the Loop Amplifier causes the varactor in the Reference Oscillator to change capacitance an amount exactly equal to the change in the Measuring Oscillator capacitance due to the glass wall thickness. The capacitance versus voltage characteristics of the varactor are known, and accordingly, this data can be inverted to form a voltage versus capacitance chart. Varactor capacitance varies slowly as a function of applied voltage. This chart is further shifted to a more convenient voltage scale by the action of the Gain and Bias Amplifier.

The varactor voltage versus capacitance curve is non-linear. A shift in the bias point of the varactor would cause an undesirable shift in scale factor within this scheme. Accordingly, when changes occur that shift the no glass value from the desired set point, a change in voltage is made to the varactor in the Measuring Oscillator. Since the predominant changes that occur are due to temperature, the control input can be referred to as the temperature compensating input. This preserves the scale of the phase locked output.

The glass thickness signal is obtained by passing the output of the Phase Locked Loop through a limiting Low Pass Filter and a Unity Gain Buffer Amplifier. From there, it goes to an A/D Converter and thence to the computer.

Samples that correspond to no glass are processed through a feedback algorithm that makes adjustments to a D/A converter. This keeps the base frequency of both Oscillators at the same frequency, i.e., when no glass is present, the frequency will remain fixed at a selected value even with temperature changes and stray capacitance.

The Measuring Oscillator is applied as the input to a phase lock Loop where the Reference Oscillator is used as the voltage controlled oscillator (VCO) because the phase locked loop tunes the VCO allowing no steady state frequency error between it and the input frequency, the capacitance of the reference capacitance must precisely match the capacitance of the sensor/bottle combination. The voltage across the reference provides a good representation of the bottle's wall thickness, limited in practice only by the match between the Measuring Reference Oscillators and by the temperature drift coefficient and sensitivity of the varactor.

Since there is a non-linear change in capacitance as a function of thickness over the range provided by glass containers, the computer comprises a linearizer which is arranged to adjust the voltage output of the measuring oscillator means so that the voltage is linearly related to the sensed wall thickness.

The linearizer uses basic non-linear regression techniques combined with a "good sense" model of the capacitance-wall thickness relationship. While regression techniques are well known, it is also well known that their success depends on a correct choice of model. If the model does not represent the data with sufficient accuracy, the results of the regression will not be accurate. Also, it is very difficult to postulate a "good" model. The relationship between the sensor capacitance and the wall thickness of the container is very non-linear. This situation cannot be improved by better sensor design because the required circumferential resolution of the measurement is of the same order of magnitude as the wall thickness. Thus, the electric fields in the container must fall-off substantially over the range of container wall thicknesses, creating a proportionately non-linear capacitance function. The relationship between wall thickness and capacitance cannot be obtained analytically as it is a three-dimensional solution of Maxwell's equations for highly non-idealized geometries. Computer numerical solutions are possible, and while these provide insight into sensor design, they are too cumbersome and time consuming to use in a wall thickness instrument to determine the thickness value corresponding to a measured capacitance. However, as the relationship between thickness and capacitance must be linear for small thickness and as the thickness increases, the capacitance will approach some "infinite thickness" value. Assuming that the "cross-over" point between these two solutions occurs at a thickness value on the order of half the probe spacing a model can be proposed which has been shown empirically to represent wall thickness data very well. This model is as follows:

$\text{C(T) = A x T / (1 + B x T)}$

where:
C is the measured capacitance, T is the wall thickness, A is a coefficient describing the small thickness, linear relationship and B is a coefficient describing the large thickness, non-linear relationship. The "infinite thickness" capacitance is A/B and cross-over wall thickness is 1/B. This model is also easy to employ in a wall thickness device because "pseudo" linear regression techniques can be used to calculate A and B from two or more known pairs (for example determined experimentally) of C and T. The model can also be used to express T in terms of C, i.e.

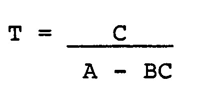

## Claims

1. Apparatus for measuring the wall thickness of a glass container comprising
a capacitance sensor (16)
container presenting means for presenting a container to engage the sensor (16)
an oscillator assembly (24) which provides an oscillating current to the sensor and an output signal representative of the capacitance sensed by the sensor
characterized in that
the apparatus also comprises computer means (30) which is responsive to the output signal and converts the output signal empirically to data representing the wall thickness according to the formula: 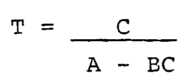 where T is the wall thickness,
C is the sensed capacitance
A is an empirically determined coefficient appropriate to the linear relationship between capacitance and thickness when the thickness is small
B is an empirically determined coefficient appropriate to the non-linear relationship between capacitance and thickness when the thickness is large.

## Patentansprüche

1. Apparat zum Prüfen der Wanddicke eines Glasbehälters, der aufweist
einen Kapazitätssensor (16),
eine Behälterzufuhreinrichtung zum Zuführen eines Behälters zum Berühren des Sensors (16),
eine Oszillatorbaugruppe (24), die einen oszillierenden Strom dem Sensor und ein Ausgangssignal bereitstellt, das repräsentativ für die durch den Sensor erfaßte Kapazität ist,
**dadurch gekennzeichnet,** daß
der Apparat auch eine Computereinrichtung (30) aufweist, die auf das Ausganssignal antwortet und das Ausganssignal empirisch zu Daten umwandelt, die die Wanddicke gemäß der Gleichung repräsentieren:
$\text{T = C/(A-BC)}$
wo T die Wanddicke ist,
C die erfaßte Kapazität ist,
A ein empirisch bestimmter Koeffizient ist, der der linearen Beziehung zwischen Kapazität und Dicke angepaßt ist, wenn die Dicke klein ist,
B ein empirisch bestimmter Koeffizient ist, der der nichtlinearen Beziehung zwischen Kapazität und Dicke angepaßt ist, wenn die Dicke groß ist

## Revendications

1. Appareil pour mesurer l'épaisseur de paroi d'un récipient en verre comprenant :
- un capteur (16) capacitif ;
- des moyens de présentation des récipients pour présenter un récipient afin de le mettre en contact avec le capteur (16) ;
- un ensemble (24) oscillateur qui transmet un courant oscillant au capteur et un signal de sortie représentatif de la capacité captée par le capteur, caractérisé en ce que :
- l'appareil comprend aussi des moyens calculateurs ordinateurs qui répondent au signal de sortie et convertissent le signal de sortie empiriquement en données représentant l'épaisseur de paroi selon la formule : 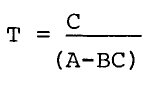 où
T est l'épaisseur de paroi,
C est la capacité mesurée,
A est un coefficient déterminé empiriquement approprié à la relation linéaire entre la capacité et l'épaisseur lorsque l'épaisseur est faible,
B est un coefficient déterminé empiriquement approprié à la relation non linéaire entre la capacité et l'épaisseur lorsque l'épaisseur est grande.
